(19) Europäisches Patentamt
European Patent Office
Office européen des brevets

(11) **EP 2 080 204 B1**

(12) **FASCICULE DE BREVET EUROPEEN**

(45) Date de publication et mention
de la délivrance du brevet:
**08.11.2017 Bulletin 2017/45**

(51) Int Cl.:
*H01G 4/10* (2006.01)       *H01G 4/33* (2006.01)
*H01G 4/06* (2006.01)       *H01G 4/12* (2006.01)
*H01L 27/01* (2006.01)      *H01L 49/02* (2006.01)

(21) Numéro de dépôt: **07858461.2**

(22) Date de dépôt: **16.10.2007**

(86) Numéro de dépôt international:
**PCT/FR2007/001701**

(87) Numéro de publication internationale:
**WO 2008/047000 (24.04.2008 Gazette 2008/17)**

(54) **CONDENSATEUR A FILMS MINCES A STABILITE ELEVEE ET PROCEDE DE FABRICATION**

HOCHSTABILER DÜNNFILMKONDENSATOR UND VERFAHREN ZU SEINER HERSTELLUNG

HIGH-STABILITY THIN-FILM CAPACITOR AND METHOD FOR MAKING THE SAME

(84) Etats contractants désignés:
**AT BE BG CH CY CZ DE DK EE ES FI GB GR HU
IE IS IT LI LT LU LV MC MT NL PL PT RO SE SI
SK TR**

(30) Priorité: **19.10.2006 FR 0609177**

(43) Date de publication de la demande:
**22.07.2009 Bulletin 2009/30**

(73) Titulaire: **Commissariat à l'Énergie Atomique
et aux Énergies Alternatives
75015 Paris (FR)**

(72) Inventeurs:
• **DEFAY, Emmanuel
  38340 Voreppe (FR)**
• **GUILLAN, Julie
  38100 Grenoble (FR)**
• **BLONKOWSKI, Serge
  38240 Meylan (FR)**

(74) Mandataire: **Hecké, Gérard et al
Cabinet Hecké
10, rue d'Arménie - Europole
BP 1537
38025 Grenoble Cedex 1 (FR)**

(56) Documents cités:
EP-A- 1 078 998       JP-A- 4 331 714
JP-A- 9 202 621       JP-A- 2000 331 877
US-A- 5 390 072       US-A- 5 978 207
US-A- 6 150 684       US-A1- 2003 184 952
US-B1- 6 190 924      US-B1- 6 495 878

• KIM, SUN JUNG: "Improvement of voltage
linearity in high -k MIM capacitors using
HfO2-SiO2 stacked dielectric" IEEE ELECTRON
DEVICE LETTERS, vol. 25, no. 8, août 2004
(2004-08), pages 538-540, XP002435867 cité dans
la demande
• JIA Q X ET AL: "LOW LEAKAGE CURRENT
BATIO3 THIN FILM CAPACITORS USING A
MULTILAYER CONSTRUCTION" THIN SOLID
FILMS, ELSEVIER-SEQUOIA S.A. LAUSANNE,
CH, vol. 259, no. 2, 15 avril 1995 (1995-04-15),
pages 264-269, XP000512226 ISSN: 0040-6090

**Description**

**Domaine technique de l'invention**

L'invention concerne un condensateur à films minces et des procédés de fabrication d'un condensateur à films minces.

**État de la technique**

Actuellement, plusieurs types de condensateurs peuvent être intégrés dans des dispositifs utilisés dans le domaine de la microélectronique. De manière générale, on peut citer :

- les condensateurs de découplage qui permettent d'éliminer les hautes fréquences parasites sur les lignes d'alimentation des dispositifs actifs,
- les condensateurs de liaison qui permettent de bloquer la tension continue entre deux blocs fonctionnels
- et les condensateurs analogiques ou les condensateurs RF disposés dans les blocs fonctionnels et qui doivent présenter une valeur de capacité très bien définie.

Ces différents types de condensateurs doivent présenter des propriétés bien précises suivant leur champ d'application. Notamment, deux paramètres caractéristiques d'un condensateur et dépendant du diélectrique utilisé sont importants : la valeur de la capacité surfacique Cs et la variation de la capacité en fonction de la polarisation qui est appliquée au condensateur.

La capacité surfacique Cs correspond au rapport entre la valeur de la capacité du condensateur et sa surface. Ainsi, pour un condensateur planaire, c'est-à-dire un condensateur formé par un empilement de films minces, la capacité surfacique Cs est égale à $\varepsilon_0.\varepsilon_r/d$, $\varepsilon_0$ correspondant à la permittivité du vide, $\varepsilon_r$ correspondant à la permittivité relative du matériau utilisé comme diélectrique et d correspondant à l'épaisseur du diélectrique. Ainsi, plus la valeur de la capacité surfacique Cs est importante, plus la taille du condensateur est faible pour une valeur donnée de capacité. Cette propriété est donc intéressante pour gagner de la place dans le dispositif comportant le condensateur, notamment pour les condensateurs à forte capacité, tels que les condensateurs de liaison et les condensateurs de découplage. Pour ce type de condensateurs, la valeur de capacité peut, en effet, atteindre quelques dizaines de nanofarads (nF) et la capacité surfacique Cs recherchée peut atteindre quelques centaines de nF/mm². Pour les capacités analogiques, la valeur typique de capacité est comprise entre 1 picoFarad (pF) et quelques dizaines de pF et la capacité surfacique recherchée est comprise entre 1 femtofarad/$\mu$m² (fF/$\mu$m²) et 10 fF/$\mu$m².

La variation de la capacité en fonction de la polarisation qui est appliquée au condensateur correspond à la variation de la capacité en fonction de la tension continue appliquée aux bornes du condensateur même si, en fonctionnement, la nature de la tension appliquée peut être continue, alternative ou les deux. Dans le cas des condensateurs analogiques notamment, la valeur de la capacité doit être la plus stable possible, quelle que soit la polarisation appliquée. Cette stabilité relative de la variation de la capacité en fonction de la polarisation appliquée correspond alors à une certaine linéarité du condensateur.

La variation de la capacité peut être modélisée en fonction de la polarisation V appliquée aux bornes du condensateur par la formule (1) suivante :

$$\frac{C}{C_0} = \alpha V^2 + \beta V + 1 \quad (1)$$

où C représente la valeur de la capacité du condensateur, $C_0$ représente la valeur de la capacité du condensateur quand la polarisation appliquée est nulle, $\alpha$ est un coefficient quadratique de capacité relative en fonction de la tension (« quadratic voltage coefficient of capacitance » ou « quadratic VCC ») et $\beta$ est un coefficient linéaire de capacité relative en fonction de la tension (« linear voltage coefficient of capacitance » ou « linear VCC »).

Pour minimiser la variation de la capacité C par rapport à la polarisation V dans un condensateur analogique, les valeurs de coefficients $\alpha$ et $\beta$ doivent être proches de zéro. Les coefficients $\alpha$ et $\beta$ sont souvent définis par rapport à la tension appliquée car la spécification des condensateurs est, en général, donnée en tension. Ainsi, pour un condensateur analogique, les valeurs requises sont de l'ordre de 100ppm/V² pour le coefficient $\alpha$ et de 100ppm/V pour le coefficient $\beta$, pour une tension maximale de 5,5V.

La valeur du coefficient $\beta$ n'est pas déterminante pour diminuer la variation de la capacité C par rapport à la polarisation V. L'effet du coefficient $\beta$ peut effectivement être facilement annulé en utilisant deux condensateurs en parallèle, connectés tête-bêche. Ainsi, les condensateurs s'ajoutent et l'effet linéaire est supprimé.

Par contre, la valeur du coefficient $\alpha$ est déterminante car il n'y a pas de moyen d'annuler cet effet quadratique par l'architecture du système. Dans le cas des condensateurs planaires ayant une capacité surfacique allant jusqu'à 2 fF/$\mu$m$^2$, le diélectrique couramment utilisé est l'oxyde de silicium (SiO$_2$) et sa constante diélectrique relative $\varepsilon_r$ est de 3,9. Ainsi, pour une capacité surfacique Cs de 2 fF/$\mu$m$^2$, l'épaisseur du diélectrique en oxyde de silicium est d'environ 17nm et les coefficients $\alpha$ et $\beta$ ont respectivement des valeurs de l'ordre de 100 ppm/V$^2$ et de 100ppm/V. Les valeurs des coefficients $\alpha$ et $\beta$ sont, dans ce cas, satisfaisantes. Cependant, lorsque la densité d'intégration est augmentée, il est nécessaire d'augmenter la capacité surfacique Cs. Or, pour atteindre une capacité surfacique Cs de 5 fF/$\mu$m$^2$, l'épaisseur du diélectrique en oxyde de silicium devrait être fortement diminuée, notamment à environ 7nm. Or, pour cette épaisseur, à 5,5V, le coefficient $\alpha$ devient supérieur à 100 ppm/V$^2$. De plus, plus l'épaisseur est réduite, plus les courants de fuite sont élevés. Ainsi, l'oxyde de silicium n'est jamais utilisé pour des capacités surfaciques supérieures à 2fF/$\mu$m$^2$.

Il a été proposé de remplacer l'oxyde de silicium par un autre matériau diélectrique. Typiquement, il peut être remplacé par HfO$_2$, Ta$_2$O$_5$, Y$_2$O$_3$, ZrO$_2$ ou Al$_2$O$_3$. Ces matériaux présentent, en effet, une constante diélectrique relative comprise entre 9 pour Al$_2$O$_3$ et 25 pour Ta$_2$O$_5$ et ils permettent d'obtenir une capacité surfacique élevée. Cependant, les coefficients $\alpha$ et $\beta$ sont trop élevés. A titre d'exemple, HfO$_2$ présente un coefficient $\alpha$ de l'ordre de 400 ppm/V$^2$ pour une capacité surfacique de 5 fF/$\mu$m$^2$.

Pour obtenir une capacité surfacique élevée tout en améliorant la linéarité des condensateurs analogiques, Sun Jung Kim et al., dans l'article « Improvement of Voltage Linearity in High-K MIM Capacitors Using HfO2-SiO2 Stacked Dielectric » (IEEE Electron Device Letters, Vol. 25, N°8, August 2004, p538-540) ont proposé d'annuler l'effet du coefficient quadratique $\alpha$ en utilisant, comme diélectrique, un empilement comportant une couche mince de 4 nm d'épaisseur en SiO$_2$ et une couche mince de 12 nm d'épaisseur en HfO$_2$. En effet, l'oxyde de silicium et l'oxyde d'hafnium présentent des coefficients quadratiques de capacité relative en fonction de la tension (« quadratic VCC ») de signes opposés. Avec un choix particulier d'épaisseur pour les deux couches minces, il est possible d'obtenir un empilement diélectrique présentant un coefficient quadratique $\alpha$ proche de zéro ($\alpha$ = 14 ppm/V$^2$) et une capacité surfacique élevée (Cs = 6 fF/$\mu$m$^2$).

De la même manière, dans la demande de brevet US2006/0017136, le diélectrique d'un condensateur analogique est constitué d'un empilement d'une couche mince inférieure présentant un coefficient quadratique de capacité relative en fonction de la tension négatif, d'une couche mince intermédiaire présentant un coefficient quadratique de capacité relative en fonction de la tension positif et d'une couche mince supérieure présentant un coefficient quadratique de capacité relative en fonction de la tension négatif. Les couches minces inférieure et supérieure sont, par exemple, en SiO$_2$ ou en Ta$_2$O$_5$ tandis que la couche mince intermédiaire est, par exemple, en HfO$_2$, ZrO$_2$ ou LaO$_3$.

Dans la demande de brevet EP1517360, le diélectrique est également formé par trois couches minces, en matériau à haute capacité. Les couches minces inférieure et supérieure présentent un coefficient quadratique de capacité relative en fonction de la tension dont la valeur absolue est relativement plus faible que celle du coefficient quadratique de capacité relative en fonction de la tension de la couche intermédiaire. Par contre, la couche intermédiaire présente un courant de fuite relativement plus faible que celui des couches supérieure et inférieure.

La capacité de tels condensateurs, comportant plusieurs couches minces diélectriques formées par des matériaux ayant des coefficients quadratiques de capacité relative en fonction de la tension différents, est stable par rapport à la polarisation appliquée. Cependant, leur fabrication est difficile à mettre en oeuvre.

Le document US 5,390,072 décrit un condensateur à films minces comprenant deux couches minces constituées du même matériau diélectrique respectivement sous forme polycristalline et amorphe.

**Objet de l'invention**

L'invention a pour but un condensateur à films minces ayant une capacité surfacique élevée et une stabilité en tension améliorée tout en étant facile à fabriquer.

Selon l'invention, ce but est atteint par les revendications annexées 1 à 3 ainsi que par les revendications 7 à 9.

L'invention a également pour but un procédé de fabrication d'un condensateur à films minces ayant une capacité surfacique élevée et une stabilité en tension améliorée, facile à mettre en oeuvre.

Selon l'invention, ce but est atteint par les revendications annexées 4 à 6.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente la variation relative de la capacité C de deux condensateurs comprenant chacun une couche

diélectrique en SrTiO$_3$, respectivement amorphe et cristallin et disposée entre deux électrodes en platine, en fonction de la polarisation V appliquée.

- la figure 2 représente, sous forme de schéma-blocs, un procédé de détermination des épaisseurs respectives des couches minces en oxyde métallique respectivement sous forme amorphe et cristallin.
- la figure 3 représente, schématiquement, en coupe un premier mode de réalisation d'un condensateur selon l'invention.
- la figure 4 représente la variation de l'épaisseur d'une couche mince en SrTiO$_3$ amorphe et d'une couche mince en SrTiO$_3$ cristallin en fonction de la capacité surfacique Cs.
- la figure 5 représente, schématiquement, en coupe un second mode de réalisation d'un condensateur selon l'invention.
- la figure 6 représente la variation de la capacité surfacique d'un condensateur à films minces comprenant un diélectrique sous forme d'une couche mince en SrTiO$_3$ et la variation du coefficient $\alpha$ de ladite couche mince, en fonction de la température de traitement thermique.

## Description de modes particuliers de réalisation

Un condensateur à films minces, et plus particulièrement un condensateur analogique à films minces, comporte au moins deux électrodes séparées par un diélectrique.

Dans un premier mode de réalisation, le diélectrique est constitué par la superposition d'au moins deux couches minces constituées par un même oxyde métallique, respectivement sous forme cristalline et amorphe. Plus particulièrement, l'oxyde métallique est un matériau pérovskite. Comme il peut être démontré expérimentalement, les matériaux pérovskites présentent, en effet, dans leur phase cristalline un coefficient quadratique de capacité relative en fonction de la tension (coefficient $\alpha$) de signe opposé à celui présenté par au moins une phase amorphe. Plus particulièrement, la forme cristalline du matériau pérovskite présente un coefficient $\alpha$ négatif tandis que, pour la forme amorphe, le coefficient $\alpha$ est positif.

Le matériau pérovskite peut, par exemple, être choisi parmi les matériaux pérovskites suivants : SrTiO$_3$ également connu sous le nom STO, (PbZr)TiO$_3$ également connu sous le nom PZT, (PbMg)NbO$_3$ - PbTiO$_3$, BaTiO$_3$ également connu sous le nom BTO, (K, Na)NbO$_3$ également connu sous le nom KNN, Ba$_2$Na$_2$Nb$_5$O$_{15}$ également connu sous le nom de BSN et BaZn$_{1/3}$Nb$_{2/3}$O$_3$ également connu sous le nom de BZN.

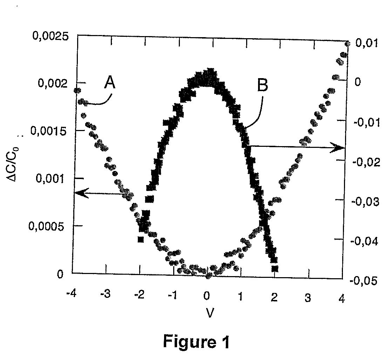

Ainsi, à titre d'illustration, sur la figure 1, les courbes A et B représentent chacune la variation expérimentale de la valeur de capacité $\Delta C/C_0$ d'un empilement comportant deux électrodes en platine séparées par une couche diélectrique en SrTiO$_3$ (STO), en fonction de la polarisation V appliquée entre les deux électrodes. La courbe A correspond à la couche mince en STO sous forme amorphe tandis que la courbe B correspond à la couche mince en STO sous forme cristalline. Les deux électrodes en platine ont chacune une épaisseur de 100nm et les couches minces en STO ont une épaisseur de 100nm.

On constate sur la figure 1 que les courbes A et B peuvent être modélisées par la formule générale (1) :. La courbe A présente une concavité tournée vers le haut, ce qui indique que, pour le matériau amorphe, le coefficient $\alpha$ est positif tandis que, la courbe B ayant une concavité tournée vers le bas, le coefficient $\alpha$ est négatif pour le matériau cristallin.

De plus, les épaisseurs d$_a$ et d$_c$ des deux couches minces constituées par le même matériau pérovskite et respectivement sous forme amorphe et cristalline sont également prédéterminées, de manière à obtenir un diélectrique présentant un coefficient quadratique de capacité relative en fonction de la tension le plus proche possible de zéro, ce qui améliore la stabilité en tension du condensateur.

Les épaisseurs d$_a$ et d$_c$ peuvent, par exemple, être choisies de manière à répondre aux formules générales (2) et (3) suivantes :

$$d_a = \frac{\varepsilon_0 \varepsilon_a}{C_{s0}} \left( \frac{1}{1 - \left(\dfrac{\varepsilon_c}{\varepsilon_a}\right)^2 \dfrac{\gamma_a}{\gamma_c}} \right) \quad (2)$$

et

**4**

$$d_c = \frac{\varepsilon_0 \varepsilon_c}{C_{s0}} \left( \frac{1}{1 - \left(\dfrac{\varepsilon_a}{\varepsilon_c}\right)^2 \dfrac{\gamma_c}{\gamma_a}} \right) \quad (3)$$

dans lesquelles :

- $\varepsilon_0$ correspond à la permittivité du vide,
- $\varepsilon_c$ et $\varepsilon_a$ correspondent aux permittivités relatives du matériau pérovskite respectivement sous forme cristalline et sous forme amorphe
- $C_{s0}$ correspond à la capacité surfacique totale à champ nul et, plus particulièrement, à la valeur constante souhaitée pour la capacité surfacique du condensateur, également appelée valeur cible
- et $\gamma_c$ et $\gamma_a$ correspondent aux coefficients quadratiques de capacité relative en fonction du champ électrique du matériau pérovskite respectivement sous forme cristalline et sous forme amorphe.

Les formules générales (2) et (3) sont, plus particulièrement, obtenues à partir :

- de la relation (4) ci-dessous permettant d'exprimer la capacité surfacique à champ nul $C_{s0}$ de l'empilement des deux couches minces en fonction des constantes diélectriques relatives $\varepsilon_a$ et $\varepsilon_c$ respectivement des deux couches :

$$C_{s0} = \varepsilon_0 \frac{\varepsilon_a \varepsilon_c}{\varepsilon_a d_c + \varepsilon_c d_a} \quad (4)$$

- et de la formule générale (5) ci-dessous modélisant la linéarité d'une couche mince diélectrique en fonction du champ électrique.

$$\frac{C}{C_0} = \gamma E^2 + \delta E + 1 \quad (5)$$

Les coefficients $\gamma$ et $\delta$, correspondent respectivement au coefficient quadratique de capacité relative en fonction du champ électrique et au coefficient linéaire de capacité relative en fonction du champ électrique. Ce sont des paramètres intrinsèques au matériau formant ladite couche mince diélectrique.

Les deux couches minces respectivement amorphe et cristalline et superposées formant, avec les électrodes, deux condensateurs en série, la capacité surfacique Cs du condensateur formé par l'empilement des deux couches minces disposées entre deux électrodes répond donc à la formule suivante :

$$C_s = \frac{C_{sa} C_{sc}}{C_{sa} + C_{sc}} \quad (6)$$

où $C_{sa}$ correspond à la capacité surfacique de la couche mince amorphe et $C_{sc}$ correspond à la capacité surfacique de la couche mince cristalline.

De plus, en première approximation, le paramètre $\delta$ peut être négligé dans la formule (5) puisque, comme le paramètre $\beta$, l'effet linéaire de la polarisation sur la valeur de la capacité peut être, de manière usuelle annulé. Ainsi, selon la formule (5), on a également :

$$\frac{C_{sa}}{C_{sa0}} = 1 + \gamma_a E_a^2 \quad (7)$$

et

$$\frac{C_{sc}}{C_{sc0}} = 1 + \gamma_c E_c{}^2 \quad (8)$$

avec $C_{sa0}$ et $C_{sr0}$ correspondant à la capacité surfacique à champ nul respectivement des couches minces amorphe et cristalline, $\gamma_c$ et $\gamma_a$ correspondent aux coefficients quadratiques de capacité relative en fonction du champ électrique des couches minces respectivement sous forme cristalline et sous forme amorphe et $E_a$ et $E_c$ correspondant au champ électrique appliqué aux couches minces respectivement sous forme cristalline et sous forme amorphe.

Ainsi, en supposant que $C_s$ est invariant suivant le champ appliqué, c'est-à-dire $Cs = C_{s0}$, la formule (6) peut être développée en insérant les formules (7) et (8). De plus, les deux couches minces amorphe et cristalline étant superposées, la conservation du vecteur déplacement $\vec{D}$ à l'interface induit $\varepsilon_a Ea = \varepsilon_c Ec$, $\vec{D}$ étant le vecteur déplacement électronique défini par Maxwell. Par ailleurs, les coefficients $\gamma_a$ et $\gamma_c$ étant faibles, la formule (6) peut subir un développement limité. Ainsi, en ne conservant que le terme d'ordre 2 en E, on obtient l'expression suivante entre les épaisseurs des couches minces amorphe et cristalline :

$$\frac{d_a}{d_c} = -\left(\frac{\varepsilon_a}{\varepsilon_c}\right)^3 \frac{\gamma_c}{\gamma_a} \quad (9).$$

En combinant l'équation (6) avec l'équation (9), on obtient les formules (2) et (3) permettant de déterminer les épaisseurs $d_a$ et $d_c$ des deux couches minces à déposer pour former le diélectrique, pour une valeur de capacité surfacique $C_{s0}$ souhaitée, indépendante de la variation de $E^2$ et, de préférence, supérieure ou égale à 5 fF/$\mu$m$^2$ et préférentiellement supérieure ou égale à 10 fF/$\mu$m$^2$.

Les formules générales (2) et (3) dépendent donc non seulement de la capacité surfacique à champ nul $C_{s0}$ correspondant à la capacité surfacique désirée pour le condensateur mais également des coefficients $\gamma_c$ et $\gamma_a$, correspondent respectivement aux coefficients quadratiques de capacité relative en fonction du champ électrique du matériau pérovskite respectivement sous forme cristalline et sous forme amorphe. Il est, alors, possible, en fonction de la capacité surfacique désirée pour le condensateur, de déterminer les épaisseurs $d_a$ et $d_c$ nécessaires pour obtenir un diélectrique présentant un coefficient quadratique de capacité en fonction de la tension le plus proche possible de zéro, ce qui permet d'obtenir un condensateur présentant une bonne stabilité en tension.

Par ailleurs, le matériau pérovskite utilisé pour former le diélectrique peut être remplacé par tout type d'oxyde métallique présentant sous forme cristalline un coefficient quadratique de capacité relative en fonction de la tension de signe opposé à celui du coefficient quadratique de capacité relative en fonction de la tension d'une forme amorphe dudit oxyde. A titre d'exemple, l'oxyde métallique peut être de l'oxyde de titane. De plus, le diélectrique peut être formé par plusieurs paires de couches minces en matériau pérovskite ou en oxyde métallique, respectivement sous forme cristalline et sous forme amorphe.

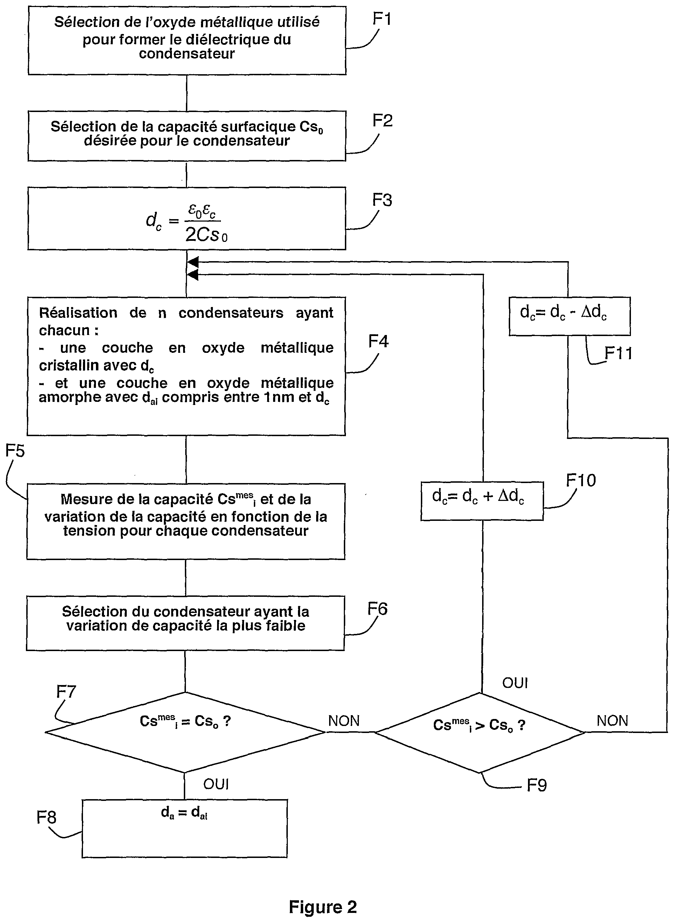

De même, l'utilisation des formules générales (2) et (3), pour déterminer les épaisseurs $d_a$ et $d_c$, de manière à permettre d'obtenir une bonne stabilité en tension peut être remplacée par une méthode empirique telle que celle représentée sur la figure 2.

En fonction de l'oxyde métallique, par exemple un matériau pérovskite, utilisé pour former le diélectrique du condensateur (étape F1) et en fonction de la valeur de capacité surfacique $Cs_0$ désirée (étape F2), les épaisseurs $d_a$ et $d_c$ peuvent être déterminées en réalisant, dans un premier temps (étape F4), une pluralité de condensateurs comportant chacun deux électrodes séparées par un diélectrique. Le diélectrique de chaque condensateur est constitué par une superposition d'une couche mince en oxyde métallique sous forme cristalline et d'une couche mince constituée par le même oxyde métallique mais sous une forme amorphe.

Pour chaque condensateur, la couche mince sous forme cristalline a la même épaisseur prédéterminée $d_c$.

Cette épaisseur $d_c$ est préalablement choisie de manière à répondre à la formule suivante : $d_c = \dfrac{\varepsilon_0 \varepsilon_c}{2Cs_o}$ (étape F3)

où $\varepsilon_o$ correspond à la permittivité du vide et $\varepsilon_c$ est la constante diélectrique dudit oxyde métallique sous forme cristalline.

Les couches minces sous forme amorphe de la pluralité de condensateurs ont des épaisseurs $d_{ai}$ prédéterminées différentes, respectivement comprises entre 1 nm et $d_{ci}$.

Ensuite, lors de l'étape F5, la capacité surfacique $Cs^{mes}{}_i$ de chaque condensateur est mesurée ainsi que la variation de la capacité en fonction de la tension appliquée pour chaque condensateur.

Le condensateur ayant la variation de capacité en fonction de la tension appliquée la plus faible est, alors, sélectionné à l'étape F6, parmi la pluralité de condensateurs. Puis, la valeur de la capacité surfacique mesurée $Cs^{mes}_i$ dudit condensateur sélectionné est comparée, à l'étape F7, avec la valeur prédéterminée de capacité surfacique $Cs_o$ souhaitée pour le condensateur.

Comme indiqué par la sortie OUI de l'étape F7, si l'on constate lors de l'étape F7 que la valeur de capacité surfacique $Cs^{mes}_i$ du condensateur sélectionné est égale à la valeur de la capacité surfacique $Cs_o$ désirée pour le condensateur, l'épaisseur à déterminer $d_a$ pour la couche mince sous forme amorphe correspond alors à l'épaisseur $d_{ai}$ de la couche mince sous forme amorphe du condensateur sélectionné, comme indiqué à l'étape F8. Dans ce cas, l'épaisseur à déterminer $d_c$ pour la couche mince sous forme cristalline correspond à la valeur choisie lors de l'étape F3.

La sortie NON de l'étape F7 indique que la valeur de la capacité surfacique $Cs^{mes}_i$ du condensateur sélectionné est différente de la valeur de la capacité surfacique $Cs_o$ désirée pour le condensateur. Dans ce cas, les étapes F4 à F7 sont réitérées en modifiant d'une valeur prédéterminée $\Delta d_c$ la valeur de $d_c$, avec, par exemple, $\Delta d_c = 20\%$.

Plus particulièrement, une étape supplémentaire F9 de comparaison est réalisée à la sortie NON de l'étape F7, de manière à déterminer si la valeur $Cs^{mes}_i$ est supérieure à la valeur $Cs_o$. Si la comparaison réalisée à l'étape F7 est positive, (sortie OUI de l'étape F9), c'est-à-dire si $Cs^{mes}_i > Cs_o$, les étapes F4 à F7 sont réitérées, en augmentant de $\Delta d_c$ la valeur de $d_c$ (étape F10), afin de diminuer la valeur de $Cs^{mes}_i$. Si la comparaison réalisée à l'étape F7 est négative, (sortie NON de l'étape F9), c'est-à-dire $Cs^{mes}_i < Cs_o$, les étapes F4 à F7 sont réitérées, en diminuant de $\Delta d_c$ la valeur de $d_c$ (étape F11), afin d'augmenter la valeur de $Cs^{mes}_i$.

Ainsi, le fait de mettre deux couches minces diélectriques en série, respectivement formées par un même oxyde métallique prédéterminé mais dans deux états distincts et le fait de choisir des épaisseurs prédéterminées selon une valeur de capacité surfacique souhaitée (correspondant à $C_{s0}$) permettent d'obtenir un coefficient quadratique de capacité relative en fonction de la tension (coefficient $\alpha$), pour l'empilement formé par les deux couches minces, le plus proche possible de zéro. Ceci améliore la stabilité du condensateur.

De plus, le condensateur peut également avoir une capacité surfacique élevée, plus particulièrement supérieure à $5fF/\mu m^2$ et avantageusement supérieure à $10fF/\mu m^2$. A titre d'exemple, lorsqu'ils sont sous forme cristalline, les matériaux pérovskites présentent l'avantage d'avoir une constante diélectrique relative $\varepsilon_r$ très élevée, généralement comprise entre 100 et 1500. Or, cette propriété apporte la possibilité d'obtenir un condensateur présentant une capacité surfacique $Cs_o$ très élevée.

Enfin, la fabrication du condensateur est facilitée par l'utilisation d'un même oxyde métallique pour former les deux couches minces. En effet, un tel condensateur peut être fabriqué selon au moins les étapes successives suivantes :

- dépôt sur une première électrode d'un oxyde métallique amorphe formant une première couche mince d'une épaisseur prédéterminée $d_c$ et cristallisation par recuit,
- dépôt, sur la première couche mince, du même oxyde métallique amorphe formant une seconde couche mince d'une épaisseur prédéterminée $d_a$
- et formation sur la seconde couche mince d'une seconde électrode.

La cristallisation par recuit peut être réalisée après le dépôt de l'oxyde métallique amorphe sur la première électrode ou bien il peut être réalisé pendant le dépôt, en particulier par chauffage in situ.

Un tel procédé facilite la fabrication d'un condensateur à films minces présentant une stabilité élevée et une forte valeur de capacité. En effet, le diélectrique est formé à partir d'un seul oxyde métallique, ce qui permet d'utiliser une même enceinte de dépôt. La cristallisation de la première couche mince est, ainsi, réalisée de manière moins coûteuse. La technique de dépôt de la seconde couche mince en oxyde métallique amorphe peut être de tout type dans la mesure où elle permet de conserver l'oxyde métallique sous sa forme amorphe après ledit dépôt. Ainsi, certaines techniques de dépôt réalisées à chaud, telles que le dépôt chimique organométallique en phase vapeur (MOCVD), peuvent être utilisées.

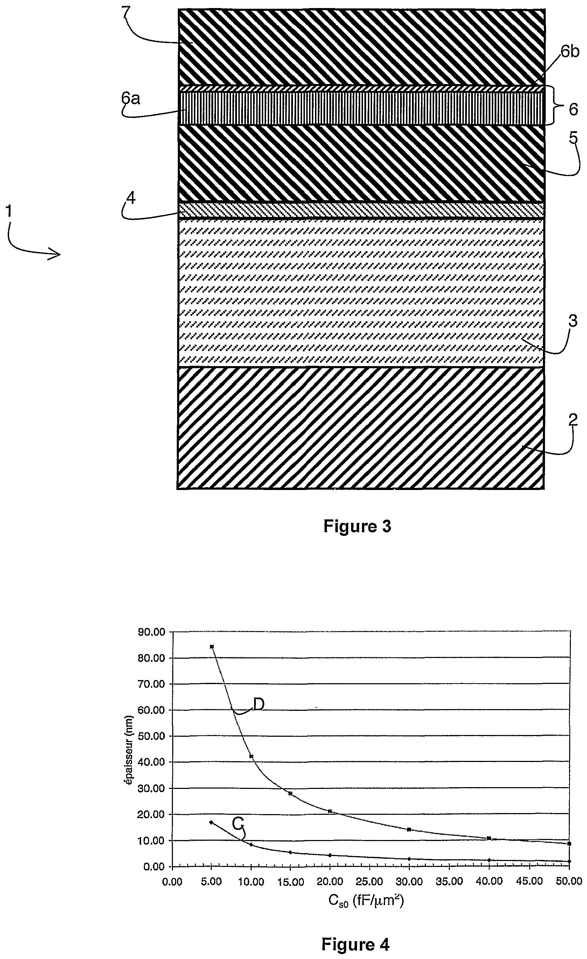

A titre d'exemple, un condensateur à films minces 1 est illustré sur la figure 3. Il comporte un substrat 2, par exemple en silicium sur lequel sont successivement disposées :

- une couche mince isolante 3, par exemple en oxyde de silicium 3 et d'une épaisseur de 500nm,
- une couche mince d'accrochage 4, par exemple en oxyde de titane et d'une épaisseur de 20nm,
- une première électrode 5, par exemple en platine et d'une épaisseur de 100nm,
- un empilement 6 formé d'une couche mince 6a en $SrTiO_3$ (STO) cristallin d'une épaisseur prédéterminée $d_a$ et d'une couche mince 6b réalisée en STO mais sous forme amorphe et d'une épaisseur prédéterminée $d_c$,
- et une seconde électrode 7, par exemple en platine et d'une épaisseur de 100nm.

La couche mince d'accrochage 4 permet, plus particulièrement, de réaliser une bonne adhésion de la première électrode 5 sur le substrat 2.

La couche mince cristalline 6a est, par exemple, formée en déposant une couche mince en STO amorphe par pulvérisation par faisceau d'ions (IBS ou « Ion Beam Sputtering »), à température ambiante et en réalisant un recuit de cristallisation à 500°C. La couche mince amorphe 6b est, par exemple, déposée par IBS.

Pour le matériau pérovskite STO cristallin, $\gamma_c$ = -1,6.10$^{-17}$ m$^2$/V$^2$ et $\varepsilon_c$ = 100 tandis que, pour le matériau STO amorphe, $\gamma_a$ = 4,7.10$^{-19}$ m$^2$/V$^2$ et $\varepsilon_a$ = 18. Ainsi, pour une valeur de capacité surfacique Cs$_o$ de 10fF/$\mu$m$^2$, les formules générales (2) et (3) permettent de déterminer que les épaisseurs respectives $d_c$ et $d_a$ des couches minces 6a et 6b. $d_c$ et $d_a$ sont respectivement de l'ordre de 42nm et de 8,4nm. Ceci est également observé sur la figure 4, sur laquelle sont reportées les courbes C et D représentant, selon les formules générales (2) et (3), la variation des épaisseurs $d_a$ et $d_c$ des couches de STO amorphe et cristalline, en fonction de la capacité surfacique $C_{s0}$ souhaitée.

Bien qu'il ait déjà été proposé de réaliser des condensateurs comprenant un diélectrique sous forme de deux couches minces superposées, réalisées en un même matériau pérovskite et respectivement cristalline et amorphe (voir demande de brevet US2003/0184952 et brevet US6190924), l'ajout de la couche amorphe n'était destinée dans l'art antérieur qu'à réduire les courants de fuite susceptibles de se produire lorsqu'une couche cristalline était employée. Or, selon un mode particulier de réalisation de l'invention, le fait de choisir des épaisseurs prédéterminées selon une valeur de capacité surfacique souhaitée permet d'obtenir un coefficient quadratique de capacité relative en fonction de la tension (coefficient $\alpha$), pour l'empilement formé par les deux couches minces, proche de zéro. Ceci améliore la stabilité en tension du condensateur, en rendant la valeur de la capacité du condensateur la moins dépendante possible de la polarisation V appliquée au condensateur.

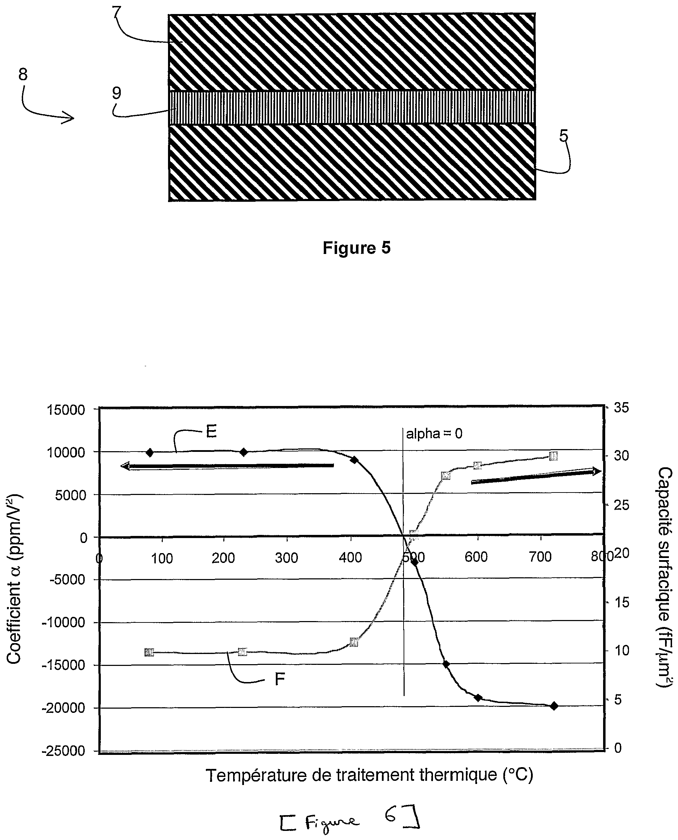

Dans un second mode de réalisation tel que représenté, à titre d'exemple, sur la figure 5, une capacité surfacique élevée, de préférence supérieure ou égale à 10fF/$\mu$m$^2$, et une stabilité en tension améliorée peuvent également être obtenues avec un diélectrique formé par une couche mince unique 9 en matériau pérovskite. Le matériau pérovskite est, par exemple, choisi parmi SrTiO$_3$, Pb(Zr, Ti)O$_3$, Pb(Mg, Nb)O$_3$-PbTiO$_3$, BaTiO$_3$, (K, Na)NbO$_3$, Ba$_2$Na$_2$Nb$_5$O$_{15}$ et BaZn$_{1/3}$Nb$_{2/3}$O$_3$.

Or, comme indiqué précédemment, les matériaux pérovskites présentent un coefficient quadratique de capacité relative en fonction de la tension non nul et dont le signe varie en fonction de la structure amorphe ou cristalline. Selon un mode particulier de réalisation, il est possible d'obtenir un condensateur à films minces comportant un diélectrique sous forme d'une couche mince unique constituée par un matériau pérovskite, avec un coefficient quadratique de capacité relative en fonction de la tension (coefficient $\alpha$) le plus proche possible de zéro. Ceci est, plus particulièrement, réalisé en modifiant la microstructure de la couche mince 9 en matériau pérovskite préalablement déposée, sur une première électrode 5, sous forme amorphe.

La microstructure de ladite couche mince 9 est modifiée par un traitement thermique, par exemple par recuit laser ou par chauffage in-situ. Le traitement thermique peut donc être réalisé après le dépôt de la couche mince 9, en matériau pérovskite amorphe, ou bien pendant ledit dépôt. Cependant, au lieu de cristalliser totalement la couche mince 9 comme précédemment, le traitement thermique est ici réalisé à une température prédéterminée particulière. Cette température correspond à la température à laquelle se produit la transition entre la phase cristalline et la phase amorphe, de sorte que le matériau pérovskite présente un coefficient $\alpha$ proche de zéro et de préférence compris entre -1000 ppm/V$^2$ et + 1000 ppm/V$^2$ et avantageusement entre -100 ppm/V$^2$ et +100 ppm/V$^2$ et encore plus avantageusement égal à zéro.

Une seconde électrode 7 est, ensuite, formée sur ladite couche mince 9.

A titre d'exemple, comme représenté sur la figure 6, une pluralité de condensateurs à films minces est réalisée en déposant une couche mince en STO amorphe d'une épaisseur de 20 nm sur une électrode métallique en platine de 100 nm d'épaisseur.

Pour chaque condensateur, la couche mince en STO amorphe subit un traitement thermique, sous atmosphère contrôlée, à une température prédéterminée, avant qu'une deuxième électrode métallique, par exemple une électrode en platine d'une épaisseur de 100 nm, ne soit déposée. La température de traitement thermique est différente pour chaque condensateur et elle varie dans une gamme comprise entre 0°C et 800°C.

Puis, la capacité surfacique est mesurée pour chaque condensateur ainsi que le coefficient $\alpha$ de chaque couche mince en STO. A titre d'exemple, le coefficient $\alpha$ de chaque couche mince est déterminé en mesurant la variation de la capacité du condensateur correspondant en fonction de la tension continue appliquée audit condensateur, avec un impédancemètre. Chaque valeur de capacité est reportée sur un graphique en fonction de la tension continue appliquée et la formule générale (1) $\dfrac{C}{C_0} = \alpha V^2 + \beta V + 1$ permet d'extraire du graphique le coefficient $\alpha$.

Ces valeurs sont reportées sur la figure 6 où la courbe E représente la variation du coefficient $\alpha$ en fonction de la température de traitement thermique tandis que la courbe F représente la variation de la capacité surfacique en fonction de la température de recuit.

On constate, sur la figure 6, que le coefficient α évolue de -20000 ppm/V² à +10000 ppm/V² entre 0°C et 800°C et qu'il existe une température pour laquelle le coefficient α est nul. La température correspondant à une valeur nulle du coefficient α est de 480°C. La courbe F permet de déterminer, pour cette température de traitement thermique, la capacité surfacique obtenue pour le condensateur. Elle est de l'ordre de 22 fF/μm². Ainsi, en réalisant un traitement thermique à 480°C, la couche mince en STO présente un coefficient α nul et la capacité surfacique du condensateur contenant une telle couche mince est de 22 fF/μm².

Le matériau pérovskite utilisé pour former le diélectrique dans le deuxième mode de réalisation peut être remplacé par tout type d'oxyde métallique qui, lorsqu'il subit, sous forme amorphe, un traitement thermique à une température prédéterminée, présente un coefficient α proche de zéro et de préférence compris entre -1000 ppm/V² et + 1000 ppm/V² et avantageusement entre -100 ppm/V² et +100 ppm/V² et encore plus avantageusement égal à zéro. L'oxyde métallique est, par exemple, l'oxyde de titane.

**Revendications**

1. Condensateur à films minces (1) comportant au moins deux électrodes (5, 7) séparées par un diélectrique (6) constitué par la superposition d'au moins deux couches minces (6a, 6b) présentant respectivement des coefficients quadratiques de capacité relative en fonction de la tension de signes opposés,
condensateur **caractérisé en ce que** les deux couches minces (6a, 6b) sont constituées par un même oxyde métallique, respectivement sous forme cristalline et amorphe, les épaisseurs respectives $d_a$ et $d_c$ des couches minces amorphe (6b) et cristalline (6a) répondant aux formules générales suivantes :

$$d_a = \frac{\varepsilon_0 \varepsilon_a}{C_{s0}} \left( \frac{1}{1 - \left(\frac{\varepsilon_c}{\varepsilon_a}\right)^2 \frac{\gamma_a}{\gamma_c}} \right) \quad et \quad d_c = \frac{\varepsilon_0 \varepsilon_c}{C_{s0}} \left( \frac{1}{1 - \left(\frac{\varepsilon_a}{\varepsilon_c}\right)^2 \frac{\gamma_c}{\gamma_a}} \right)$$

où :

$\varepsilon_0$ correspond à la permittivité du vide,

$\varepsilon_c$ et $\varepsilon_a$ correspondent aux permittivités relatives de l'oxyde métallique respectivement sous forme cristalline et sous forme amorphe

$C_{s0}$ correspond à la capacité surfacique totale à champ nul

$\gamma_c$ et $\gamma_a$ correspondent aux coefficients quadratiques de capacité relative en fonction du champ électrique de l'oxyde métallique respectivement sous forme cristalline et sous forme amorphe.

2. Condensateur selon la revendication 1, **caractérisé en ce que** l'oxyde métallique est choisi parmi un matériau pérovskite et l'oxyde de titane.

3. Condensateur selon la revendication 2, **caractérisé en ce que** le matériau pérovskite est choisi parmi $SrTiO_3$, $Pb(Zr, Ti)O_3$, $Pb(Mg, Nb)O_3$-$PbTiO_3$, $BaTiO_3$, $(K, Na)NbO_3$, $Ba_2Na_2Nb_5O_{15}$ et $BaZn_{1/3}Nb_{2/3}O_3$.

4. Procédé de fabrication d'un condensateur à films minces (1), **caractérisé en ce qu'**il comporte au moins les étapes successives suivantes :

- dépôt sur une première électrode (5) d'un oxyde métallique amorphe formant une première couche mince (6a) d'une épaisseur prédéterminée $d_c$ et cristallisation par recuit,
- dépôt sur la première couche mince (6a) du même oxyde métallique amorphe formant une seconde couche mince (6b) d'une épaisseur prédéterminée $d_a$
- et formation sur la seconde couche mince (6b) d'une seconde électrode (7)

et **en ce que** les épaisseurs $d_a$ et $d_c$ répondent respectivement aux formules générales suivantes :

$$d_a = \frac{\varepsilon_0 \varepsilon_a}{C_{s0}} \left( \frac{1}{1 - \left(\frac{\varepsilon_c}{\varepsilon_a}\right)^2 \frac{\gamma_a}{\gamma_c}} \right) \quad et \quad d_c = \frac{\varepsilon_0 \varepsilon_c}{C_{s0}} \left( \frac{1}{1 - \left(\frac{\varepsilon_a}{\varepsilon_c}\right)^2 \frac{\gamma_c}{\gamma_a}} \right)$$

où :

$\varepsilon_0$ correspond à la permittivité du vide,
$\varepsilon_c$ et $\varepsilon_a$ correspondent aux permittivités relatives de l'oxyde métallique respectivement sous forme cristalline et sous forme amorphe
$C_{s0}$ correspond à la capacité surfacique totale à champ nul
$\gamma_c$ et $\gamma_a$ correspondent aux coefficients quadratiques de capacité relative en fonction du champ électrique de l'oxyde métallique respectivement sous forme cristalline et sous forme amorphe.

5. Procédé selon la revendication 4, **caractérisé en ce que** la cristallisation par recuit est réalisée après le dépôt de l'oxyde métallique amorphe, sur la première électrode (5).

6. Procédé selon la revendication 4, **caractérisé en ce que** la cristallisation par recuit est réalisée en même temps que le dépôt de l'oxyde métallique amorphe, sur la première électrode (5).

7. Procédé de détermination des épaisseurs respectives de deux couches minces superposées, constituées par un même oxyde métallique respectivement sous forme cristalline et amorphe et formant le diélectrique d'un condensateur à films minces ayant une valeur prédéterminée de capacité surfacique $Cs_o$,
procédé **caractérisé en ce qu'**il comporte au moins les étapes successives suivantes :

a) fixation de l'épaisseur $d_c$ de la couche mince en oxyde métallique sous forme cristalline à la valeur égale a

$\dfrac{\varepsilon_0 \varepsilon_c}{2Cs_0}$ où $\varepsilon_o$ correspond à la permittivité du vide et $\varepsilon_c$ est la constante diélectrique dudit oxyde métallique sous forme cristalline

b) réalisation d'une pluralité de condensateurs comportant chacun deux électrodes séparées par un diélectrique constitué par une superposition :

- d'une couche mince en oxyde métallique sous forme cristalline d'épaisseur $d_c$
- et d'une couche mince en oxyde métallique sous forme amorphe ayant une épaisseur $d_{ai}$ prédéterminée comprise entre 1 nm et $d_c$ et différente pour chaque condensateur

c) mesure de la capacité surfacique $Cs^{mes}_i$ de chaque condensateur et mesure de la variation de la capacité en fonction de la tension appliquée pour chaque condensateur
d) sélection, parmi la pluralité de condensateurs, du condensateur ayant la variation de capacité en fonction de la tension appliquée la plus faible
e) comparaison de la capacité surfacique mesurée $Cs^{mes}_i$ du condensateur sélectionné avec la valeur prédéterminée de capacité surfacique $Cs_o$:

- si $Cs^{mes}_i = Cs_o$, l'épaisseur à déterminer pour la couche mince sous forme amorphe correspond à l'épaisseur $d_{ai}$ de la couche mince sous forme amorphe du condensateur sélectionné et l'épaisseur à déterminer pour la couche mince sous forme cristalline correspond à l'épaisseur $d_c$,
- sinon, les étapes b) à e) sont réitérées en modifiant d'une valeur $\Delta d_c$ prédéterminée la valeur de $d_c$.

8. Procédé selon la revendication 7, **caractérisé en ce que**, si $Cs^{mes}_i > Cs_o$, les étapes b) à e) sont réitérées en augmentant de $\Delta d_c$ la valeur de $d_c$.

9. Procédé selon la revendication 7, **caractérisé en ce que**, si $Cs^{mes}_i < Cs_o$, les étapes b) à e) sont réitérées en diminuant de $\Delta d_c$ la valeur de $d_c$.

**Patentansprüche**

1. Dünnfilmkondensator (1), der wenigstens zwei Elektroden (5, 7) umfasst, welche durch ein Dielektrikum (6) getrennt sind, das durch Übereinanderlegen von wenigstens zwei dünnen Schichten (6a, 6b) mit jeweils quadratischen Koeffizienten relativer Kapazität in Abhängigkeit von der Spannung mit entgegengesetzten Vorzeichen gebildet ist, wobei der Kondensator **dadurch gekennzeichnet ist, dass** die beiden dünnen Schichten (6a, 6b) von einem gleichen Metalloxid, in kristalliner bzw. in amorpher Form, gebildet sind, wobei die jeweiligen Dicken $d_a$ und $d_c$ der dünnen amorphen Schicht (6b) und der dünnen kristallinen Schicht (6a) die folgenden allgemeinen Formeln verfüllen:

$$d_a = \frac{\varepsilon_0 \varepsilon_a}{C_{s0}} \left( \frac{1}{1 - \left( \frac{\varepsilon_c}{\varepsilon_a} \right)^2 \frac{\gamma_a}{\gamma_c}} \right) \quad \text{und} \quad d_c = \frac{\varepsilon_0 \varepsilon_c}{C_{s0}} \left( \frac{1}{1 - \left( \frac{\varepsilon_a}{\varepsilon_c} \right)^2 \frac{\gamma_c}{\gamma_a}} \right)$$

worin:

$\varepsilon_0$ der Permittivität des Vakuums entspricht,
$\varepsilon_c$ und $\varepsilon_a$ den relativen Permittivitäten des Metalloxids in kristalliner Form bzw. in amorpher Form entsprechen
$C_{s0}$ der Gesamtoberflächenkapazität bei Feld Null entspricht
$\gamma_c$ und $\gamma_a$ den quadratischen Koeffizienten relativer Kapazität in Abhängigkeit von dem elektrischen Feld des Metalloxids in kristalliner Form bzw. in amorpher Form entsprechen.

2. Kondensator nach Anspruch 1, **dadurch gekennzeichnet, dass** das Metalloxid aus einem Perowskit-Material und Titanoxid ausgewählt ist.

3. Kondensator nach Anspruch 2, **dadurch gekennzeichnet, dass** das Perowskit-Material aus $SrTiO_3$, $Pb(Zr, Ti)O_3$, $Pb(Mg, Nb)O_3$-$PbTiO_3$, $BaTiO_3$, $(K, Na)NbO_3$, $Ba_2Na_2Nb_5O_{15}$ und $BaZn_{1/3}Nb_{2/3}O_3$ ausgewählt ist.

4. Verfahren zur Herstellung eines Dünnfilmkondensators (1), **dadurch gekennzeichnet, dass** es wenigstens die folgenden aufeinanderfolgenden Schritte umfasst:

- Abscheiden eines amorphen Metalloxids, das eine erste dünne Schicht (6a) mit einer vorbestimmten Dicke $d_c$ bildet, auf einer ersten Elektrode (5), und Kristallisation durch Glühen,
- Abscheiden des gleichen amorphen Metalloxids, das eine zweite dünne Schicht (6b) mit einer vorbestimmten Dicke $d_a$ bildet, auf der ersten dünnen Schicht (6a), und
- Ausbilden einer zweiten Elektrode (7) auf der zweiten dünnen Schicht (6b), und dadurch, dass die Dicken $d_a$ und $d_c$ jeweils die folgenden allgemeinen Formeln erfüllen:

$$d_a = \frac{\varepsilon_0 \varepsilon_a}{C_{s0}} \left( \frac{1}{1 - \left( \frac{\varepsilon_c}{\varepsilon_a} \right)^2 \frac{\gamma_a}{\gamma_c}} \right) \quad \text{und} \quad d_c = \frac{\varepsilon_0 \varepsilon_c}{C_{s0}} \left( \frac{1}{1 - \left( \frac{\varepsilon_a}{\varepsilon_c} \right)^2 \frac{\gamma_c}{\gamma_a}} \right)$$

worin:

$\varepsilon_0$ der Permittivität des Vakuums entspricht,
$\varepsilon_c$ und $\varepsilon_a$ den relativen Permittivitäten des Metalloxids in kristalliner Form bzw. in amorpher Form entsprechen
$C_{s0}$ der Gesamtoberflächenkapazität bei Feld Null entspricht
$\gamma_c$ und $\gamma_a$ den quadratischen Koeffizienten relativer Kapazität in Abhängigkeit von dem elektrischen Feld des Metalloxids in kristalliner Form bzw. in amorpher Form entsprechen.

**5.** Verfahren nach Anspruch 4, **dadurch gekennzeichnet, dass** die Glüh-Kristallisation nach dem Abscheiden des amorphen Metalloxids auf der ersten Elektrode (5) durchgeführt wird.

**6.** Verfahren nach Anspruch 4, **dadurch gekennzeichnet, dass** die Glüh-Kristallisation zur gleichen Zeit wie das Abscheiden des amorphen Metalloxids auf der ersten Elektrode (5) durchgeführt wird.

**7.** Verfahren zur Bestimmung der jeweiligen Dicken von zwei übereinanderliegenden dünnen Schichten, die durch ein gleiches Metalloxid in kristalliner bzw. in amorpher Form gebildet sind und die das Dielektrikum eines Dünnfilmkondensators mit einem vorbestimmten Wert der Oberflächenkapazität $Cs_0$ bilden,
wobei das Verfahren **dadurch gekennzeichnet ist, dass** es wenigstens die folgenden aufeinanderfolgenden Schritte umfasst:

a) Festlegen der Dicke $d_c$ der dünnen Schicht aus Metalloxid in kristalliner Form auf den Wert gleich $\dfrac{\varepsilon_0 \varepsilon_c}{2Cs_0}$

worin $\varepsilon_0$ der Permittivität des Vakuums entspricht und $\varepsilon_c$ die Dielektrizitätskonstante des Metalloxids in kristalliner Form ist,
b) Herstellen einer Vielzahl von Kondensatoren, die jeweils zwei Elektroden umfassen, welche durch ein Dielektrikum getrennt sind, das gebildet ist durch ein Übereinanderlegen:

- von einer dünnen Schicht aus Metalloxid in kristalliner Form mit der Dicke $d_c$ und
- von einer dünnen Schicht aus Metalloxid in amorpher Form mit einer vorbestimmten Dicke $d_{ai}$, die im Bereich zwischen 1 nm und $d_c$ liegt und für jeden Kondensator unterschiedlich ist,

c) Messen der Oberflächenkapazität $Cs^{mes}_i$ eines jeden Kondensators und Messen der Änderung der Kapazität in Abhängigkeit von der angelegten Spannung für jeden Kondensator
d) Auswählen, aus der Vielzahl von Kondensatoren, des Kondensators, der die geringste Änderung der Kapazität in Abhängigkeit von der angelegten Spannung aufweist
e) Vergleichen der gemessenen Oberflächenkapazität $Cs^{mes}_i$ des ausgewählten Kondensators mit dem vorbestimmten Wert der Oberflächenkapazität $Cs_0$:

- wenn $Cs^{mes}_i = Cs_0$, so entspricht die für die dünne Schicht in amorpher Form zu bestimmende Dicke der Dicke $d_{ai}$ der dünnen Schicht in amorpher Form des ausgewählten Kondensators und entspricht die für die dünne Schicht in kristalliner Form zu bestimmende Dicke der Dicke $d_c$,
- andernfalls werden die Schritte b) bis e) wiederholt, indem der Wert von $d_c$ um einen vorbestimmten Wert $\Delta d_c$ geändert wird.

**8.** Verfahren nach Anspruch 7, **dadurch gekennzeichnet, dass** wenn $Cs^{mes}_i > Cs_0$, die Schritte b) bis e) wiederholt werden, indem der Wert von $d_c$ um $\Delta d_c$ erhöht wird.

**9.** Verfahren nach Anspruch 7, **dadurch gekennzeichnet, dass** wenn $Cs^{mes}_i < Cs_0$, die Schritte b) bis e) wiederholt werden, indem der Wert von $d_c$ um $\Delta d_c$ verringert wird.

**Claims**

**1.** Thin film capacitor (1) comprising at least two electrodes (5,7) separated by a dielectric (6) formed by superposition of at least two thin layers (6a, 6b) respectively presenting quadratic coefficients of capacitance in function to the tension of opposite signs,
capacitor **characterized in that** the two thin layers (6a, 6b) are made of a same metal oxide, respectively in crystalline form and in amorphous form, the respective thicknesses $d_a$ and $d_c$ of the amorphous (6b) and crystalline (6a) thin layers complying with the following general formulas:

$$d_a = \frac{\varepsilon_0 \varepsilon_a}{C_{s0}} \left( \frac{1}{1 - \left(\dfrac{\varepsilon_c}{\varepsilon_a}\right)^2 \dfrac{\gamma_a}{\gamma_c}} \right) \quad and \quad d_c = \frac{\varepsilon_0 \varepsilon_c}{C_{s0}} \left( \frac{1}{1 - \left(\dfrac{\varepsilon_a}{\varepsilon_c}\right)^2 \dfrac{\gamma_c}{\gamma_a}} \right)$$

where :

$\varepsilon_0$ corresponds to vacuum permittivity,
$\varepsilon_c$ and $\varepsilon_a$ respectively correspond to the relative permittivity of the metal oxide in crystalline form and the relative permittivity of the metal oxide in amorphous form,
$C_{s0}$ corresponds to the total surface capacitance at zero field,
$\gamma_c$ and $\gamma_a$ correspond to the quadratic coefficients of capacitance in function to the electric field of the metal oxide respectively in crystalline form and in amorphous form.

2. Capacitor according to claim 1, **characterized in that** the metal oxide is chosen from a perovskite material and titanium oxide.

3. Capacitor according to claim 2, **characterized in that** the perovskite material is chosen from $SrTiO_3$, $Pb(Zr, Ti)O_3$, $Pb(Mg, Nb)O_3$-$PbTiO_3$, $BaTiO_3$, $(K, Na)NbO_3$, $Ba_2Na_2Nb_5O_{15}$ and $BaZn_{1,3}Nb_{2,3}O_3$.

4. Method for producing a thin-film capacitor (1), **characterized in that** it comprises at least the following successive steps :

- deposition of an amorphous metal oxide forming a first thin layer (6a) of a predetermined thickness $d_c$ on a first electrode (5) and crystallization by annealing,
- deposition of the same amorphous metal oxide on the first thin layer (6a) forming a second thin layer (6b) of a predetermined thickness $d_a$,
- and formation of a second electrode (7) on the second thin layer (6b), and **in that** the thicknesses $d_a$ and $d_c$ respectively comply with the following general formulas:

$$d_a = \frac{\varepsilon_0 \varepsilon_a}{C_{s0}} \left( \frac{1}{1 - \left(\dfrac{\varepsilon_c}{\varepsilon_a}\right)^2 \dfrac{\gamma_a}{\gamma_c}} \right) \quad and \quad d_c = \frac{\varepsilon_0 \varepsilon_c}{C_{s0}} \left( \frac{1}{1 - \left(\dfrac{\varepsilon_a}{\varepsilon_c}\right)^2 \dfrac{\gamma_c}{\gamma_a}} \right)$$

where :

$\varepsilon_0$ corresponds to vacuum permittivity,
$\varepsilon_c$ and $\varepsilon_a$ respectively correspond to the relative permittivity of the metal oxide in crystalline form and to the relative permittivity of the metal oxide in amorphous form,
$C_{s0}$ corresponds to the total surface capacitance at zero field,
$\gamma_c$ and $\gamma_a$ correspond to the quadratic coefficients of capacitance in function to the electric field of the metal oxide respectively in crystalline form and in amorphous form.

5. Method according to claim 4, **characterized in that** crystallization by annealing is performed after deposition of the amorphous metal oxide on the first electrode (5).

6. Method according to claim 4, **characterized in that** crystallization by annealing is performed at the same time as deposition of the amorphous metal oxide on the first electrode (5).

7. Method for determining the respective thicknesses of two superposed thin layers made from a same metal oxide respectively in crystalline and amorphous form and forming the dielectric of a thin-film capacitor having a predetermined value of surface capacitance $Cs_o$,
method **characterized in that** it comprises at least the following successive steps:

a) fixing the thickness $d_c$ of the thin layer of metal oxide in crystalline form to a value equal to $\dfrac{\varepsilon_0 \varepsilon_c}{2Cs_0}$ where

$\varepsilon_o$ corresponds to vacuum permittivity and $\varepsilon_c$ is the dielectric constant of said metal oxide in crystalline form
b) producing a plurality of capacitors each comprising two electrodes separated by a dielectric formed by superposition:

- of a thin layer of metal oxide in crystalline form of thickness $d_c$
- and a thin layer of metal oxide in amorphous form having a predetermined thickness $d_{ai}$ comprised between 1nm and $d_c$ that is different for each capacitor

c) measuring the surface capacitance $Cs^{mes}_i$ of each capacitor and measuring the variation of the capacitance in function to the applied voltage for each capacitor
d) selecting the capacitor having the smallest capacitance variation in function to the applied voltage, from the plurality of capacitors
e) comparing the measured surface capacitance $Cs^{mes}_i$ of the selected capacitor with the predetermined value of surface capacitance $Cs_o$:

- if $Cs^{mes}_i = Cs_o$, the thickness to be determined for the thin layer in amorphous form corresponds to the thickness $d_{ai}$ of the thin layer in amorphous form of the selected capacitor and the thickness to be determined for the thin layer in crystalline form corresponds to the thickness $d_c$,
- if not, steps b) to e) are reiterated modifying the value of $d_c$ by a predetermined value $\Delta d_c$.

8. Method according to claim 7, **characterized in that**, if $Cs^{mes}_i > Cs_o$, steps b) to e) are reiterated increasing the value of $d_c$ by $\Delta d_c$.

9. Method according to claim 7, **characterized in that**, if $Cs^{mes}_i < Cs_o$, steps b) to e) are reiterated decreasing the value of $d_c$ by $\Delta d_c$.

**Figure 1**

Sélection de l'oxyde métallique utilisé pour former le diélectrique du condensateur — F1

Sélection de la capacité surfacique $Cs_0$ désirée pour le condensateur — F2

$$d_c = \frac{\varepsilon_0 \varepsilon_c}{2Cs_0}$$ — F3

Réalisation de n condensateurs ayant chacun :
- une couche en oxyde métallique cristallin avec $d_c$
- et une couche en oxyde métallique amorphe avec $d_{ai}$ compris entre 1nm et $d_c$ — F4

$d_c = d_c - \Delta d_c$ — F11

F5 — Mesure de la capacité $Cs^{mes}_i$ et de la variation de la capacité en fonction de la tension pour chaque condensateur

$d_c = d_c + \Delta d_c$ — F10

Sélection du condensateur ayant la variation de capacité la plus faible — F6

F7 — $Cs^{mes}_i = Cs_o$ ?  NON  $Cs^{mes}_i > Cs_o$ ? NON  OUI

OUI

F9

F8 — $d_a = d_{ai}$

**Figure 2**

**Figure 3**

**Figure 4**

**Figure 5**

Température de traitement thermique (°C)

[ Figure 6 ]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060017136 A
- EP 1517360 A
- US 5390072 A
- US 20030184952 A
- US 6190924 B

**Littérature non-brevet citée dans la description**

- **SUN JUNG KIM et al.** Improvement of Voltage Linearity in High-K MIM Capacitors Using HfO2-SiO2 Stacked Dielectric. *IEEE Electron Device Letters,* Août 2004, vol. 25 (8), 538-540